(19) Europäisches Patentamt / European Patent Office / Office européen des brevets

(11) **EP 3 011 582 B1**

(12) **EUROPÄISCHE PATENTSCHRIFT**

(45) Veröffentlichungstag und Bekanntmachung des Hinweises auf die Patenterteilung:
**03.03.2021   Patentblatt 2021/09**

(21) Anmeldenummer: **14731254.0**

(22) Anmeldetag: **17.06.2014**

(51) Int Cl.:
*H01J 37/252* *(2006.01)*     *H01J 37/244* *(2006.01)*
*G01N 23/225* *(2018.01)*

(86) Internationale Anmeldenummer:
**PCT/EP2014/062722**

(87) Internationale Veröffentlichungsnummer:
**WO 2014/202608 (24.12.2014 Gazette 2014/52)**

(54) **VERFAHREN ZUR DETEKTION VON RÖNTGENSTRAHLEN SOWIE VORRICHTUNG**

METHOD FOR DETECTING X-RAYS AND DEVICE

PROCÉDÉ DE DÉTECTION DE RAYONS X AINSI QUE DISPOSITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2013   DE 102013211327**

(43) Veröffentlichungstag der Anmeldung:
**27.04.2016   Patentblatt 2016/17**

(73) Patentinhaber: **Bruker Nano GmbH**
**12489 Berlin (DE)**

(72) Erfinder: **TERBORG, Ralf**
**10317 Berlin (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
EP-A2- 2 216 798        EP-A2- 2 216 798
EP-A2- 2 282 197        EP-A2- 2 282 197
WO-A1-2010/115873

- **Elisa Ceccolini ET AL: "EBT2 Dosimetry of X-rays produced by the electron beam from PFMA-3, a Plasma Focus for medical applications", , 9. Dezember 2011 (2011-12-09), XP055152691, DOI: 10.1063/1.4748179 Gefunden im Internet: URL:http://arxiv.org/abs/1112.2198**
- **"Mylar-6my-Xray-Transmission", , 13. November 2014 (2014-11-13), XP055152838, Gefunden im Internet: URL:http://henke.lbl.gov/optical_constants /filter2.html [gefunden am 2014-11-13]**
- **WILSON A R ET AL: "Backscattered electron effects in a high-angle EDXS", JOURNAL OF PHYSICS E. SCIENTIFIC INSTRUMENTS, IOP PUBLISHING, BRISTOL, GB, Bd. 22, Nr. 9, 1. September 1989 (1989-09-01), Seiten 726-729, XP020019075, ISSN: 0022-3735, DOI: 10.1088/0022-3735/22/9/009**
- **MURRAY R T: "A filter to remove backscattered electrons for energy-dispersive analysis in a scanning microscope", JOURNAL OF PHYSICS E. SCIENTIFIC INSTRUMENTS, IOP PUBLISHING, BRISTOL, GB, Bd. 12, Nr. 12, 1. Dezember 1979 (1979-12-01), Seite 1141, XP007918294, ISSN: 0022-3735, DOI: 10.1088/0022-3735/12/12/007**
- **ROBERTO COSSIO ET AL: "Improvements in trace element detection in energy dispersive spectrometry using an X-ray filter (FEDS) and applications to petrological problems", MICROCHIMICA ACTA ; AN INTERNATIONAL JOURNAL ON MICRO AND TRACEANALYSIS, SPRINGER-VERLAG, VI, Bd. 161, Nr. 3-4, 20. Dezember 2007 (2007-12-20), Seiten 337-342, XP019633476, ISSN: 1436-5073**

## Beschreibung

Die Erfindung betrifft ein Verfahren zur energiedispersiven Detektion von Röntgenstrahlen bei gleichzeitiger Reduktion des Beitrags der Rückstreuelektronen durch das Bereitstellen eines geeigneten Mittels, sowie eine zur Ausführung des Verfahrens eingerichtete Vorrichtung.

## Technologischer Hintergrund

Es ist bekannt, zur Analyse von Proben in einem Rasterelektronenmikroskop (SEM) verschiedene Signale, die von der Probe abgegeben werden, heranzuziehen und auszuwerten. Zum einen ist es interessant, eine bildgebende Analyse zur Darstellung eines ortsaufgelösten Bildes ähnlich dem Bild in einem Lichtmikroskop, aber mit zusätzlicher Information an jedem Punkt über die mittlere chemische Zusammensetzung, zu erhalten. Dazu eignet sich ein Rückstreuelektronen-Detektor. Zum anderen sind detailliertere Informationen über die in der Probe an dem Punkt enthaltenen Elemente sowie deren quantitative Zusammensetzung interessant. Dies ist durch eine Elektronenstrahlmikroanalyse und die Detektion der in der Probe erzeugten Röntgenstrahlung möglich. Das Ausgabesignal ist dabei von der Ordnungszahl Z der Elemente und deren Konzentration an der untersuchten Stelle der Probe abhängig. Gebräuchliche Detektoren beinhalten Detektionselemente auf Siliziumbasis, wie lithiumgedriftete Siliziumdetektoren, Si(Li), oder Siliziumdriftdetektoren, SDD.

Beim Bestrahlen einer Probe mit einem Primärelektronenstrahl definierter Energie wird ein Teil als Rückstreuelektronen, sogenannte BSE (*backscattered electrons*), emittiert. Darüberhinaus regt der Primärelektronenstrahl Elektronen in der Probe derart an, dass es zur Erzeugung von Röntgenstrahlung kommt. Rückstreuelektronen weisen im Vergleich zu Röntgenquanten eine um ein Vielfaches höhere Intensität auf. Übliche Röntgendetektionselemente sind sowohl für Röntgenquanten, als auch für Elektronen empfindlich, so dass es zu einer Überlagerung kommt. Dies führt zu Detektionsschwierigkeiten der Röntgenstrahlen.

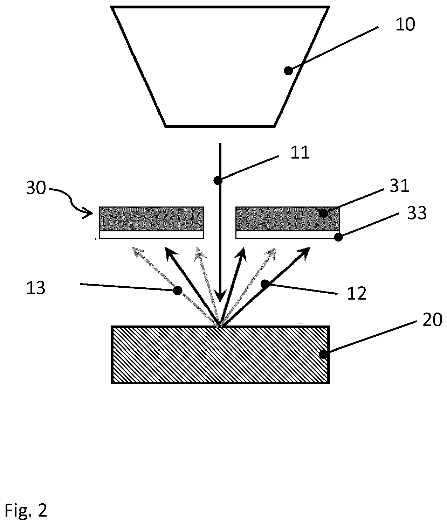

Fig. 2 zeigt einen Röntgendetektor 30 des Standes der Technik. Damit dieser Detektor 30 nur Röntgenquanten und keine BSE-Elektronen misst, wird optional ein dünnes Fenster und standardmäßig eine magnetische Elektronenfalle 32 vor den Detektor 30 gesetzt, die das Eintreten von Elektronen in den Detektor 30 durch ein geeignetes Magnetfeld verhindert.

Der Detektor ist normalerweise relativ weit von der Probe und dem Elektronenstrahl entfernt und deshalb der Einsatz einer Elektronenfalle unproblematisch. Damit ist aber auch der Raumwinkel und damit die Sammel-Effizienz für den Detektor relativ klein. Für kürzere Messungen oder Spektren mit besserer Statistik ist ein größerer Raumwinkel sinnvoll. Dies wird durch eine größere Detektor-Fläche oder größeren Raumwinkel durch einen geringeren Abstand zu Probe möglich. Ist der Detektor sehr nah an der Probe, so ist er auch in unmittelbarer Nähe des Elektronenstrahls. In diesem Fall kann das Magnetfeld der Elektronenfalle auch die Elektronen des Primärstrahls beeinflussen und die Qualität negativ beeinflussen.

WO 2010/115873 beschreibt einen in Figur 2 dargestellten Detektor 35. Dieser ist ausgebildet gleichzeitig Röntgenstrahlung und Rückstreuelektronen energiedispersiv aufzunehmen. Zu diesem Zweck weist er ein zwischen Detektorelement und Probe angeordnetes Fenster 33 auf, das den Beitrag der Rückstreuelektronen reduziert, jedoch nur soweit, dass diese noch auswertbar sind. EP2216798 beschreibt dazu zwei Fenster mit unterschiedlicher Transmission für Elektronen auf einem Träger.

Bei vielen Geometrien ist es aufgrund des fehlenden Platzes oder Wechselwirkungen mit dem Magnetfeld unmöglich eine Elektronenfalle zu verwenden.

Alternativ kann anstelle einer magnetischen Elektronenfalle ein Fenster mit einer geringen Transmission für Rückstreuelektronen verwendet werden, das ein Eindringen der BSE verhindert. Das dicke Fenster verringert jedoch in so starkem Maße die Transmission niederenergetischer Röntgenstrahlung, das die Analyse von Röntgenstrahlung unterhalb einer bestimmten Energie, z.B. 1 keV, nicht mehr möglich ist. Der Detektor hat damit eine schlechte oder keine Niederenergie-Performance.

Gewerblich sind diverse Fenster für dispersive röntgenographische Untersuchungen, wie Elektronenmikroskopie, Röntgenteleskopie und Röntgenspektroskopie erhältlich. Ansätze zur Erhöhung der Stabilität solcher Fenster sind unter anderem in US 7,709,820 B2 und US 2013/0094629 A1 beschrieben. Beide Veröffentlichungen beschreiben eine Anordnung, in der je ein Fenster unterschiedlicher Bauart auf je einem Rahmen angebracht ist und mit diesem vor einen Röntgendetektor zu befestigen ist.

## Zusammenfassung der Erfindung

Der Erfindung liegt daher die Aufgabe zugrunde, ohne die Verwendung einer magnetischen Elektronenfalle Röntgenspektren qualitativ und quantitativ messbar zu machen.

Diese Aufgabe ist durch ein Verfahren, sowie eine Vorrichtung mit den Merkmalen der unabhängigen Ansprüche gelöst.

Entsprechend wird ein Verfahren zur energiedispersiven Aufnahme von Röntgenstrahlung bereitgestellt, das folgende Schritte umfasst:

- Bestrahlen einer Probe mit einem Primärelektronenstrahl unter Anregung einer Emission von Röntgenstrahlung und Rückstreuelektronen,
- Bereitstellen eines Mittels zur Reduktion der Rückstreuelektronen, umfassend eine Halterung mit mindestens zwei Fenstern mit unterschiedlichen Transmissionseigenschaften für Rückstreuelektronen,

- Positionieren eines der mindestens zwei Fenster der Halterung zwischen der Probe und einem Röntgendetektionselement,
- Detektieren der Röntgenstrahlung mittels des Röntgendetektionselements, wobei

das eine der mindestens zwei Fenster so gewählt wird, dass in einem vorbestimmten Energiebereich an jedem charakteristischen Röntgenpeak den größtmöglichen Transmissionsgrad $T_X$ für Röntgenstrahlen aufweist und der Transmissionsgrad $T_{BSE}$ für Rückstreuelektronen höchstens 0,1 beträgt. Vorzugsweise gilt dies für den gesamten Energiebereich. Der Transmissionsgrad ist durch das Verhältnis aus der Intensität I(E) austretender Strahlung zur Intensität I(I) eintreffender Strahlung definiert, also $T = \dfrac{I(E)}{I(I)}$.

Die Messung der Probe wird dann mit dem, der Bedingung entsprechendem Fenster durchgeführt. Die Wahl des idealen Fensters bietet den Vorteil, dass es insbesondere während der gesamten Messung, möglich ist, eine maximale Transmission der gewünschten Röntgenstrahlung bei gleichzeitig vernachlässigbarem Anteil von Rückstreuelektronen (BSE) am Röntgendetektionselement zu detektieren Dies ermöglicht qualitativ und quantitativ zu messen. Von den mindestens zwei Fenstern wird vorteilhafterweise in Abhängigkeit vom Versuchsaufbau das geeignete ausgewählt und positioniert. Dies reduziert den experimentellen und apparativen Aufbau erheblich, insbesondere dann, wenn der Austausch während der Messung, insbesondere während einer Testmessung, ohne Rückbau des Versuchsaufbaus erfolgen kann.

Im idealen Fall passieren keine Elektronen (weder Rückstreu-, noch Sekundärelektronen) das vor dem Röntgendetektionselement positionierte Fenster. Da in diesem Fall jedoch eine zu starke Blockierung der Röntgenstrahlung verursacht würde, wird erfindungsgemäß eine maximale Transmission von 10% der Rückstreuelektronen toleriert. Dies gilt im gesamten erfassten Messbereich, insbesondere jedoch im Bereich charakteristischer Peaks. Charakteristische Peaks sind Intensitäten im Röntgenspektrum, die typisch für eine bestimmte Zusammensetzung der Probe sind. Anhand der Lage im Spektrum und der Intensität der Peaks im Verhältnis zu einander können Elemente oder Verbindungen den Peaks zugeordnet werden und die Zusammensetzung der Probe im gemessenen Bereich bestimmt werden. Ist der Untergrund klein, ermöglicht die integrale Bestimmung der Peaks zusätzlich eine quantitative Bestimmung der Probe. Je geringer der Untergrund im Bereich der charakteristischen Peaks, desto höher die Qualität der Messung, desto niedriger der Messfehler und desto eindeutiger das Ergebnis.

Je geringer der Beitrag der Rückstreuelektronen im gesamten Spektrum, desto höher die Qualität. Um die Qualität zu erhöhen, insbesondere um die quantitative Bestimmung zu verbessern, ist in einer bevorzugten Ausführung des erfindungsgemäßen Verfahrens der Transmissionsgrad $T_{BSE}$ kleiner als 0,05, insbesondere kleiner als 0,02. Mit anderen Worten, lediglich 5% der Rückstreuelektronen, insbesondere 2% der Rückstreuelektronen, passieren das vor dem Röntgendetektionselement positionierte Fenster und werden somit von dem Röntgendetektionselement detektiert.

Die Transmissionseigenschaften beziehungsweise das Absorptionsverhalten, welche für Röntgenstrahlung und Elektronen unterschiedliches Verhalten zeigen können der Fenster ist unter anderem eine Materialeigenschaft. Dem folgend ist beispielsweise die Anzahl der Rückstreuelektronen in bevorzugter Ausführungsform des erfindungsgemäßen Verfahrens unter anderem über die Auswahl des Fenstermaterials einstellbar. Dies ist insbesondere dann von Vorteil, wenn die Lage der charakteristischen Peaks der zu analysierenden Probe bereits bekannt ist. Dann kann ein Material gewählt werden, welches in dem Energiebereich der Röntgen-Peaks die Rückstreuelektronen besonders gut absorbiert und/oder die Röntgenstrahlen der angeregten Probe besonders wenig absorbiert. Vorteilhafterweise können darüberhinaus solche Materialien gewählt werden, die den Bedingungen des Versuchsaufbaus entsprechen. Beispielsweise gegenüber Vakuum stabil sind, wie Beryllium, ungiftig sind wie Aluminium oder flexibel wie Mylar®. Bevorzugte Materialien können Polymere, z. B Mylar® ($C_{16}H_8O_4$) oder Parylene N® ($C_8H_8$), aber auch verschiedene Reinelemente wie Be, C, Al, Si beziehungsweise Verbindungen wie $Si_3N_4$ sein.

In weiter bevorzugter Ausgestaltung der Erfindung kann der Anteil der, auf das Röntgendetektionselement auftreffenden, Elektronen durch die Wahl der Fensterdicke eingestellt werden. Dabei nimmt mit zunehmender Dicke des Fensters die Absorption für Rückstreuelektronen zu beziehungsweise die Transmission für Elektronen ab. Im Gegensatz zur Auswahl des Fensters anhand des Fenstermaterials nimmt das Absorptionsvermögen der Fenster stetig mit steigender Dicke zu. Mit der Wahl eines dickeren Fensters kann also der Transmissionsgrad für Elektronen erhöht oder erniedrigt werden, ohne dass sich das materialspezifische Transmissionsverhalten für Röntgenstrahlen im Verlauf des Energiebereichs, beispielsweise zu dem im Vorfeld positionierten Fenster, prinzipiell ändert. Bevorzugte Fensterstärken liegen im Bereich von 0,1 μm bis 50 μm, bevorzugter im Bereich von 0,25 μm bis 20 μm, noch bevorzugter im Bereich von 0,5 μm bis 10 μm.

Die Nutzung beider Vorteile, nämlich Nutzen des materialspezifischen Transmissionsverhaltens gegenüber Röntgenstrahlung und Elektronen bei gleichzeitigem Erhöhen bzw. Erniedrigen des absoluten Transmissionsvermögens, geregelt über die Fensterdicke, ist durch eine Kombination beider Auswahlkriterien möglich. Es ist daher bevorzugt, ein Fenster anhand der Fensterdicke und des Fenstermaterials so auszuwählen, dass der Anteil der Röntgenstrahlung möglichst hoch ist und gleichzeitig der Anteil der Rückstreuelektronen möglichst vernachlässigbar.

Um den Wechsel des Fensters zu beschleunigen, ist es von Vorteil, wenn die Positionierung des, nach oben genannten Kriterien ausgewählten, Fensters manuell oder automatisch, insbesondere sowohl manuell als auch automatisch, erfolgen kann. In beiden Fällen wird das Mittel zur Aufnahme der mindestens zwei Fenster betätigt und somit das ausgewählte Fenster vor dem Röntgendetektionselement positioniert. Die Automatisierung der Fensterauswahl bietet den Vorteil eines automatischen Betriebs eines Detektors.

Weiter bevorzugt ist es, wenn ein Austausch der Fenster während des Betriebs erfolgen kann. Somit kann insbesondere nach einer Testmessung und /oder bei automatisiertem Probenwechsel unter Unterbrechung ein Fensterwechsel erfolgen, sodass sichergestellt ist, dass für die Messung jede Probe das nach oben beschriebenem Kriterium günstigste Fenster ausgewählt wird. Ebenso wie die Automatisierung kann dadurch in vorteilhafter Weise eine automatische Messung ermöglicht werden. Insbesondere ist es bevorzugt, wenn der Austausch des Fensters, beispielsweise durch Betätigen des Mittels, im Betrieb unter Vakuum erfolgen kann. Dies minimiert den apparativen Aufwand beim Fensterwechsel enorm, da das Mittel zur Aufnahme der mindestens zwei Fenster bedingt durch den Versuchsaufbau den gleichen Druckverhältnissen ausgesetzt ist wie die Probe. Ist ein Fensterwechsel ausschließlich bei heruntergefahrenem Aufbau möglich, sind mit einem Fensterwechsel stets auch ein aktiver Druckausgleich und späterer Druckab- bzw. aufbau verbunden.

Im Sinne der Erfindung ist die Automatisierung des Austauschs der Fenster bevorzugt mittels einer Hardware/Software-Einheit gesteuert. Neben der maschinellen Komponente des reinen Positionierens der Fenster kann über eine geeignete Verknüpfung nicht nur der Austausch sondern darüberhinaus die Auswahl des Fensters automatisiert erfolgen.

Der Automatisierungsgrad nimmt umso mehr zu, je unabhängiger die Messung vom Experimentator ist. Erfolgt die Auswahl des geeigneten Fensters über automatisierbare Kriterien, ist die Messung nahezu vollständig automatisierbar.

Die Energie des Primärionenstrahls ist ein bevorzugtes Kriterium für die Auswahl eines geeigneten Fensters. Generell gilt, je höher die Energie der Primärelektronen, desto höher die Energie der Rückstreuelektronen und desto niedriger der Transmissionsgrad des zu wählenden Fensters. In der Software hinterlegt sind geeignete Algorithmen zur Auswahl des Fensters. Den Algorithmen können dabei rechnerische und/oder empirische Studien zugrunde liegen. Erfolgt die Auswahl des vor dem Röntgendetektionselement positionierten Fensters in Abhängigkeit von der Energie des Primärelektronenstrahls, so liegt ein eindeutiges und messbares Kriterium für die Fensterauswahl vor. Insbesondere wenn eine Kommunikationsmöglichkeit zwischen der Steuerung der Hochspannung an der Quelle des Primärelektronenstrahls, der genannten Hardware/Software-Einheit als Steuerung des Fenster-Mechanismus und letztlich einem Mechanismus zum Positionieren der Fenster über das Mittel zu deren Anordnung der Fenster, realisiert ist, ist der Vorgang des Fenstertauschs automatisierbar. Da die Energie der BSE von der Energie der Primärelektronen abhängt, kann man für verschiedene Primärenergien verschieden dicke Fenster verwenden und vor den Detektor schieben, die die BSE maximaler Energie noch vollständig unterdrücken, aber die Röntgenstrahlung möglichst wenig verringern. Somit kann man bei verschiedenen Energien der Primärelektronen mit einem entsprechenden Fenster BSE-freie Spektren aufnehmen mit optimaler Fenster-Transmission für Röntgenstrahlung und somit optimaler Niederenergie-Performance aufnehmen.

Ebenfalls bevorzugt ist es, ein geeignetes Fenster anhand einer ersten Testmessung auszuwählen. Hierzu zeigt eine erste Testmessung einer, beispielsweise unbekannten, Probe die Lage der charakteristischen Peaks. Der Experimentator wählt dann ein geeignetes Fenster, bevorzugter Weise aus einem geeigneten Material in geeigneter Dicke aus. Wahlweise kann dieses Vorgehen solange wiederholt werden, bis ein geeignetes Fenster gefunden wurde. Dieses Vorgehen ist ebenfalls automatisierbar, Hierfür gibt der Experimentator nach einer ersten Auswertung der Testmessung ein Signal an die Hardware/Software-Einheit mit der Information des zu positionierenden Fensters. Alternativ kann ein Zugriff der Steuereinheit zur Wahr des Fensters auf das Spektrum realisiert werden und somit ebenfalls eine Automatisierung dieses Schritts erfolgen. Vorteil gegenüber dem Auswahlkriterium Primärstrahlenergie ist aber, dass die Messung an die Probe angepasst werden kann und damit die Peakintensität in spezifischen Bereichen bzw. für spezifische Elemente optimiert worden ist.

Im idealen Fall passieren keine Elektronen (weder hochenergetische Rückstreu- noch niederenergetische Sekundärelektronen) das vor dem Röntgendetektionselement positionierte Fenster. Da dieser Fall nur unter Inkaufnahme einer inakzeptablen Blockierung der Röntgenstrahlung zu erzielen ist, ist erfindungsgemäß unter vernachlässigbar zu verstehen, dass zumindest der Anteil der Rückstreuelektronen gegenüber dem Röntgenstrahlen möglichst gering ist. Maximal ist die Detektion von 10% der Rückstreuelektronen erlaubt. Das heißt, der Transmissionsgrad ($T_X$), als Eigenschaft des Fensters, für Röntgenstrahlung soll deutlich höher sein, als der Transmissionsgrad ($T_{BSE}$) für Rückstreuelektronen. Dabei wird der gesamte Energiebereich des gemessenen Spektrums betrachtet. Dieser Zusammenhang kann bevorzugt durch $T_X - T_{BSE} < 0,2$, bevorzugter 0,3, bevorzugter 0,4, bevorzugter 0,5, noch bevorzugter 0,6, weiterhin bevorzugt 0,8 beschrieben werden. Mit anderen Worten, an jedem charakteristischen Peak der zu analysierenden Probe soll im gesamten Spektrum der Anteil der Transmission ($T_X$) für Röntgenstrahlen deutlich größer sein, als die Transmission ($T_{BSE}$) für Rückstreuelektronen an diesem Punkt. Dabei ist zu beachten, dass mit der Energie die Intensität und damit die Transmission für Rückstreuelektronen kontinuierlich bis zu einem Wert von etwa der halben Primärenergie ansteigt und dann wieder abnimmt. Die Transmission für Röntgenstrahlung steigt zwar auch mit der Energie an, jedoch durchläuft sie mehrere Minima an den Absorptionskanten, an denen die Transmission stark einbricht. Der Verlauf und die absolute Position der Minima ist dabei eine materialspezifische Fenstereigenschaft. Hier würde auch ein sehr geringer Anteil an Rückstreuelektronen das Messergebnis stark beeinträchtigen, insbesondere wenn in diesem Bereich charakteristische Peaks liegen. Bei der Wahl eines geeigneten Fensters findet dies vozugsweise Beachtung . Es wird dann ein Fenster ausgewählt, das einen Bereich hoher Transmission für Röntgenstrahlung im Energiebereich der charakteristischen Peaks aufweist.

Alternativ zu einem herkömmlichen Detektor mit Elektronenfalle kann ein Detektor ohne Elektronenfalle verwendet werden, der dann aber ein entsprechend dickes Fenster haben muss, um ein Eindringen der BSE zu verhindern. Das dicke Fenster verringert aber in so starkem Maße die Transmission niederenergetischer Röntgenstrahlung, dass die Analyse von Röntgenstrahlung unterhalb einer bestimmten Energie, z.B. 1keV, nicht mehr möglich ist. Der Detektor hat damit eine schlechte oder keine Niederenergie-Performance. Ein weiterer Aspekt der Erfindung liegt daher in der Bereitstellung einer Vorrichtung zur energiedispersiven Aufnahme von Röntgenstrahlung gemäß Anspruch 11 mit einem Röntgendetektionselement sowie einem Mittel zur Reduktion von, in das Röntgendetektionselement einfallenden Rückstreuelektronen, wobei das Mittel mindestens zwei Fenster umfasst und die mindestens zwei Fenster unterschiedliche Transmissionseigenschaften für Elektronen aufweisen.

Das Mittel kann derart ausgebildet sein, dass mindestens eines der Merkmale gebildet aus der Gruppe der folgenden Merkmale zutrifft: die Anzahl der detektierten Rückstreuelektronen weist eine um mindestens eins kleinere Größenordnung auf als die Anzahl der detektierten Röntgenphotonen; die Summe der Flächen unter den Röntgenpeaks weist eine um mindestens eins kleinere Größenordnung auf als die Fläche des übrigen Untergrundbeitrags abzüglich des theoretischen Bremsstrahluntergrundes; die Anzahl der Pulse im Maximum des Röntgenpeaks ist mindestens das 5-fache der Anzahl der Pulse des Untergrundbeitrags in der direkten Umgebung des Peaks.

Das Röntgendetektionselement kann ein ganzer Röntgendetektor sein oder bevorzugt lediglich das eigentliche Detektionselement oder der Detektionskristall des Röntgendetektors.

Die Bestimmung, ob Rückstreuelektronen im Spektrum vorhanden sind, kann über eine bekannte Probe derart erfolgen, dass bei einer Übereinstimmung des Verlauf des Bremsstrahluntergrundes mit der Theorie keine Rückstreuelektronen vorhanden sind. Unterscheidet sich der Verlauf von der Theorie, so sind Rückstreuelektronen vorhanden.

Der Detektor ist ausgerüstet mit einem Mittel zur Reduktion des Rückstreuelektronenanteils gegenüber dem Röntgenphotonenanteil, welches die Intensität der Röntgenstrahlung nicht nennenswert verringert, aber die Anzahl der von der Probe abgegebenen, wesentlich intensiveren BSE derart verringert, dass die BSE gegenüber den Röntgenquanten nicht oder nahezu nicht messbar sind. Da nämlich die Anzahl der von der Probe abgegebenen Rückstreuelektronen BSE um mehrere Größenordnungen höher ist als die Anzahl der Röntgenphotonen, ist ohne ein spezielles Mittel zur Reduktion keine quantitative Messung möglich, das Signalverhältnis Photonen zu BSE wäre zu ungünstig. Deshalb ist ein entsprechendes Mittel, bevorzugt eine Folie oder ein Fenster, notwendig, welches eine möglichst große Zahl von Photonen ungestört durchlässt und gleichzeitig die Anzahl der BSE so verringert, das die Anzahl der Röntgenquanten mindestens eine Größenordnung über der der Rückstreuelektronen liegt.

Vorteilhafterweise unterdrückt das Mittel zur Reduktion außerdem Sekundärelektronen SE, d.h. Elektronen niedriger Energie.

Die Energieauflösung für Photonen liegt im Bereich von 130eV für Mn-K$\alpha$.

Um die Anordnung der Fenster in dem Mittel zu ermöglichen ist erfindungsgemäß beansprucht, dass das Mittel eine Halterung umfasst, auf der die mindestens zwei Fenster positioniert sind. Die Halterung kann in Form eines Rahmens ausgeführt sein. Ferner ist es erfindungsgemäß, dass durch Auswahl einer Position der Halterung jeweils ein Fenster vor das Röntgendetektionselement positionierbar ist. Dabei ist es vorteilhaft, wenn der Aufbau des Rahmens so ausgeführt ist, dass die Fenster linear oder radial angeordnet sind. Das heißt, dass die Fenster durch schieben oder Drehen der Halterung positionierbar sind. Diese Halterung kann erfindungsgemäß durch einen Steuermechanismus in Form einer Hardware/Software-Einheit und/oder manuell verschiebbar beziehungsweise drehbar sein. Dabei ist es bevorzugt, wenn die Position eines bestimmten Fensters auf der Halterung eindeutig definiert ist.

## Kurzbeschreibung der Figuren

Die Erfindung wird nachfolgend anhand eines Ausführungsbeispiels und dazugehöriger Zeichnungen näher erläutert. Die Figuren zeigen:

Fig. 1    eine Vorrichtung zur Messung von Röntgenstrahlung des Standes der Technik; mit Elektronenfalle;

Fig. 2 eine Vorrichtung zur Messung von Röntgenstrahlung des Standes der Technik mit Elektronen absorbierendem Fenster;

Fig. 3 eine erfindungsgemäße Vorrichtung zur Messung von Röntgenstrahlung, mit softwareunterstützter Regelung von, vor ein Röntgendetektionselement positionierbaren Fenstern mit verschiedenen Transmissionseigenschaften;

Fig. 4 drei Röntgenspektren einer Probe gemessen nach einer ersten Ausführung des erfindungsmäßen Verfahrens mit drei unterschiedlichen Fenstern;

Fig. 5 zwei Spektren einer Probe gemessen nach einer zweiten Ausführung des erfindungsgemäßen Verfahrens; mit zu dünnen Fenster (gestrichelte Linie) und passendem Fenster (durchgezogene Linie).

## Detaillierte Beschreibung der Erfindung

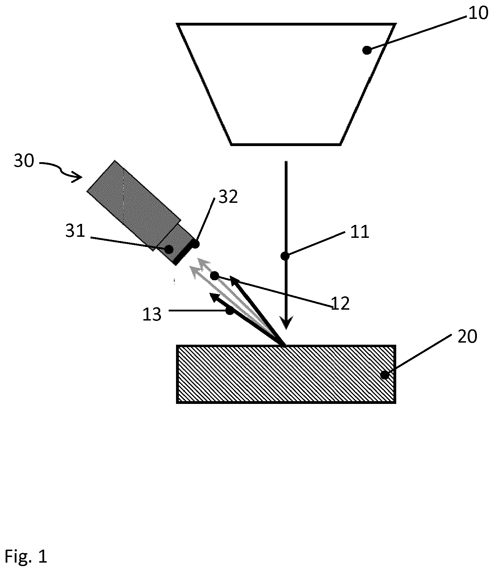

Figur 1 und 2 zeigen einen Röntgendetektor 30 des Standes der Technik, wie bereits einleitend beschrieben. Der Röntgendetektor 30 kann dabei energiedispersiv messen. Es ist aus dem Stand der Technik bekannt, dass energiedispersive Detektoren Untergrund und Peaks gleichzeitig aufzeichnen. Die Teilchen mit einer kontinuierlichen Energieverteilung werden dabei in Kanäle, die einen bestimmten Energiebereich haben, einsortiert. Man erhält ein Spektrum, in dem verschiedene Countzahlen oder Anzahl der Impulse in verschiedene Kanäle aufgenommen werden (Multi channel analyser). Die Kanäle haben eine bestimmte Breite, typischerweise 5eV, d.h. Kanal 1 zählt alle Teilchen mit einer Energie von 0-5eV, Kanal 2 alle mit 5<=E<10eV, Kanal 100 alle mit 500<=E<505eV. Dabei ist ein Peak in einem Spektrum "nachweisbar", wenn er sich vom Untergrund trennen lässt. Bekanntermaßen kann für die Nachweisbarkeitsgrenze ein linearer Untergrund unter dem Peak konstruiert werden. Dieser kann bestimmt werden, indem man an der hoch- und niederenergetischen Seite des Peaks jeweils einen Punkt festlegt, der mindestens die zweifache Halbwertsbreite des Peaks vom Zentralkanal entfernt ist und visuell im Untergrund liegt und diese beiden Punkte durch eine Gerade miteinander verbindet. Die Peakintensität P ist die Summe aller Counts im Peakbereich oberhalb dieser Linie. Der Untergrundwert U ist die Anzahl der Counts unterhalb der Linie, aber nur in dem einen Zentralkanal unterhalb des Peaks. Ein Peak liegt dann oberhalb der Nachweisbarkeitsgrenze, wenn $P >= 3 * \sqrt{(U)}$, oder in Worten, wenn die Peakfläche größer oder gleich ist dem dreifachen Wert der Quadratwurzel aus der Untergrundintensität unter dem Peak.

Figur 1 zeigt dabei den üblichen Stand der Technik, bei dem zur qualitativen Analyse der emittierten Röntgenstrahlung 13 der Probe der Beitrag an Rückstreuelektronen 12 mittels einer Elektronenfalle 32 oder eines hochabsorbierenden Fensters unterdrückt werden.

Figur 2 zeigt eine Vorrichtung ohne magnetische Elektronenfalle. Die Vorrichtung besteht aus dem Detektor 35, der ein konventionelles energiedispersives Röntgendetektionselement 31 umfasst, vor dem eingangsseitig ein Fenster 33 zur Reduktion des Beitrags der Rückstreuelektronen gegenüber dem Beitrag der Röntgenstrahlung angeordnet ist, sowie einer geeigneten Software, die Spektren erfassen und ggf. die Anteile der Photonen und BSE separieren und getrennt auswerten kann. Damit ist die Vorrichtung zur gleichzeitigen energieaufgelösten Messung von Rückstreuelektronen (BSE) 12 und Röntgenstrahlung 13 geeignet. Das Röntgendetektionselement 31 ist derart ausgebildet, dass eine Raumwinkel von $\Omega=0,1-2sr$ erfasst wird. Das Röntgendetektionselement 31 kann dabei aus mehreren Teilsektoren bestehen, die wiederum eine rechteckige Form oder die Form eines Kreiselementes haben können. Der Detektor ist im Vergleich zu dem in Figur 1 dargestellten herkömmlichen Röntgendetektor 30 direkt um den Elektronenstrahlgang zwischen Primärelektronenquelle 10 und Probe 20 angeordnet. Dies wird dadurch realisiert, dass der Detektor ein Loch aufweist, welches bevorzugt mittig im Detektor 35 angeordnet ist, durch dass die Primärelektronen 11 den Detektor 35 durchschreiten und die Probe 20 erreichen können. Von der Probe 20 werden dann die Elektronen 12 rückgestreut und es wird gleichzeitig Röntgenstrahlung 13 erzeugt. Darüberhinaus ist der Detektor 35 so mit einem Fenster 33 ausgerüstet, das die Intensität der Röntgenstrahlung 13 nicht nennenswert verringert, aber die Anzahl der von der Probe abgegebenen, wesentlich intensiveren Rückstreuelektronen (BSE) 12 entsprechend verringert, so dass Röntgenquanten und BSE gleichzeitig messbar sind.

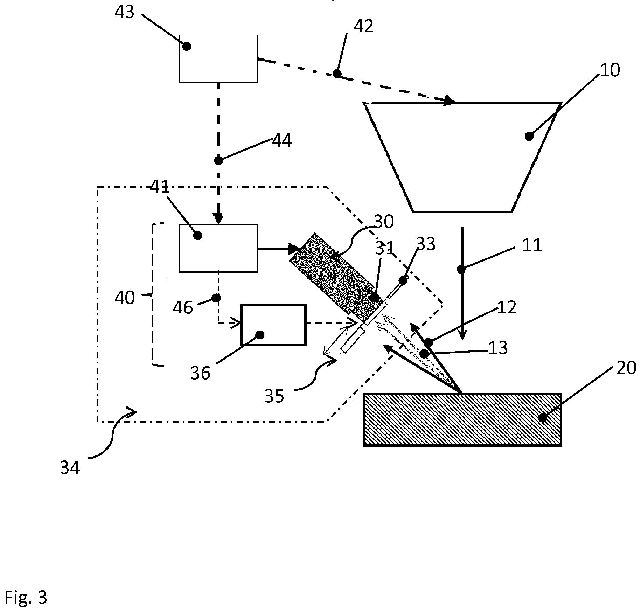

Figur 3 zeigt eine erfindungsgemäße Vorrichtung zur Messung von Röntgenstrahlung 13 ohne Verwendung einer magnetischen Elektronenfalle. Zur Messung einer Probe 20 ist in einem sogenannten Polschuh 10 eine Elektronenquelle angebracht, welche nach Parameterübertragung 42 aus einer Steuereinheit 43 einen Primärstrahl 11 definierbarer Energie erzeugt. Die Probe 20 ist so angeordnet, dass sie von dem Primärstrahl 11 an einem definierten Punkt getroffen wird. An diesem definierten Punkt kommt es zur Anregung von Röntgenstrahlung 13, die ebenso wie die von dem Primärstrahl 11 an der Probe 20 erzeugten Rückstreuelektronen 12 (BSE) von der Probe emittiert werden.

Die Implementierung umfasst einen Detektor 30 mit einem energiedispersiven Röntgendetektionselement 31, sowie ein insgesamt mit 34 bezeichnetes Mittel zur Reduktion der Rückstreuelektronen. Der Detektor 30 und die Probe 20 sind so zueinander angeordnet, dass die emittierte Strahlung von dem Röntgendetektionselement 31 absorbiert werden kann. Die genaue Position richtet sich dabei nach dem zu analysierendem Raumwinkel, wie in den Figuren 1 und 2 beschrieben.

Der Detektor 30 kann aus mehreren Detektorsektoren bestehen, die separat voneinander messen können. So kann die Gesamtfläche eines Detektors 30 kreisförmig sein, wobei die Detektorsegmente als Kreiselemente um den Mittelpunkt des Detektors 30 angeordnet sein können. Die Detektorsegmente können aber auch rechteckig oder quadratisch sein.

Das energiedispersive Röntgendetektionselement 31 ist ein Element aus einem Material, wie es zur eigentlichen Detektion von Röntgenstrahlung in einem Röntgendetektor verwendet wird. Üblicherweise handelt es sich um ein Halbleiterdetektorelement auf Silizium-Basis, wie es in einem Silziumdriftdetektor oder Si(Li) verwendet wird.

Das erfindungsgemäße Mittel 34 zur Reduktion von Rückstreuelektronen umfasst eine Mehrzahl von Fenstern 33, sowie eine Halterung 35 zu deren Aufnahme. Ferner umfasst das Mittel 34 eine Hardware/Software-Einheit 40, umfassend ein Stellmittel 36 zur Bewegung der Halterung 35 sowie eine zugehörige Steuereinheit 41. Die Hardware/Software-Einheit kommuniziert über Steuersignale 44 mit der Steuereinheit 43 des Gerätes zur Erzeugung des Elektronenstrahls (Elektronenkanone).

Das Mittel 34 umfasst in dem dargestellten Ausführungsbeispiel drei Fenster 33 mit unterschiedlicher Fensterdicke $d_F$ und/oder unterschiedlichen Materialien. Die Fensterdicke $d_F$ kann dabei zwischen 0,1 $\mu m$ und 20 $\mu m$ variieren. Als Materialien für die Fenster 33 können Polymere, z. B Mylar® ($C_{16}H_8O_4$) oder Parylene N® ($C_8H_8$), aber auch verschiedene Reinelemente wie Be, C, Al, Si beziehungsweise Verbindungen wie $Si_3N_4$ benutzt werden. Im Folgenden beziehen sich alle gezeigte Anwendungen und Experimente auf Folien 11, die aus Mylar® bestehen. Beispiele für die Foliendicken sind 1 $\mu m$ bei einer Anregungsenergie von kleiner 6 keV, 3 $\mu m$ bei einer Anregungsenergie von kleiner 12keV. Zur Nutzung verschiedener Primärenergien können Fenster 33 verschiedener Dicke, 0,1 $\mu m$, 0,2 $\mu m$, 0,5 $\mu m$, 1 $\mu m$, 2 $\mu m$, 3 $\mu m$, 6 $\mu m$ und 12 $\mu m$, eingesetzt werden, um für diese Energien einen Beitrag durch Röntgenquanten bei möglichst vernachlässigbaren Beitrag BSE zu erzielen. Im dargestellten Ausführungsbeispiel sind die drei Fenster 33 linear in der Halterung 35 angeordnet. Die Halterung 35 verfügt hier über einen Schiebemechanismus, der es ermöglicht, durch Hin- und Herschieben die Fenster zu positionieren. Ebenfalls bevorzugt sind andere nicht dargestellte Mechanismen zur Positionierung, wie beispielsweise ein drehbares Rad, an dem mehrere Fenster 33 angeordnet sein können, die durch Drehen des Rades wahlweise zwischen dem Röntgendetektionselement 31 und der Probe 20 positionierbar sind.

Die in Figur 3 dargestellte Vorrichtung zeigt folgende Funktion:
Ein Primärelektronenstrahl 11 definierter Energie regt in einer Probe 20 die Emission von Röntgenstrahlung an. Gleichzeitig werden Elektronen rückgestreut. Die emittierte Strahlung wird mittels Röntgendetektor 30 mit Röntgendetektionselement 31, detektiert.

Vor dem Auftreffen auf das Röntgendetektionselement durchdringt die von der Probe emittierte Strahlung das, jeweils zwischen Detektor und Probe positionierte Fenster 33. Die Fensterdicke $d_F$ beeinflusst ebenso wie die Verwendung des Fenstermaterials die Absorptions- und Transmissioneigenschaften des Fensters gegenüber emittierter Röntgenstrahlung 13 und Rückstreuelektronen 12. Für die Messung wird dasjenige Fenster 33 ausgewählt, das unter den Messbedingungen den größtmöglichen Transmissionsgrad $T_X$ für Röntgenstrahlen aufweist, wobei die Transmission $T_{BSE}$ der Rückstreuelektronen möglichst vernachlässigbar ist, also höchstens 0,1 beträgt und somit $T_{BSE}$ nahe 0 ist. Sowohl $T_X$ als auch $T_{BSE}$ sind dabei unter anderem von Fenstermaterial, Fensterdicke $d_F$, aber auch von der Intensität des Primärstrahls 11, sowie dem Probenmaterial abhängig. Um eine bestimmte Probe zu analysieren, wird üblicherweise eine Primärstrahlenergie so gewählt, dass sie oberhalb der 2-fachen Energie der zur charakteristischen Linie zugehörigen Absorptionskante der interessierenden Elemente liegt. In Abhängigkeit von der gewählten Primärstrahlenergie kann dann ein Fenster 33 bestimmt werden, das die oben beschriebene Bedingung erfüllt. Dies geschieht beispielsweise über Ergebnisse empirischer Studie, bei welchen für ein oder mehrere Probematerialien die Transmission für Röntgenstrahlen und Rückstreuelektronen in Abhängigkeit verschiedener Primärstrahlenergien, sowie verschiedener Fenstermaterialien und -dicken, gemessen wird. Die so erhaltenen Ergebnisse können in Kennfeldern gespeichert werden, welche in der Steuereinheit in computerlesbarer Form vorliegt. Aus derartigen Kennfeldern erfolgt die Zuordnung eines geeigneten Fensters.

Alternativ oder zusätzlich kann eine Testmessung durchgeführt werden. Zeigt beispielsweise eine Testmessung einen charakteristischen Peak in einem Energiebereich, in dem das anhand der Primärstrahlintensität ausgewählte Fenster 33 aufgrund seiner Materialeigenschaften eine ungünstige Transmission aufweist, kann das Fenster 33 gegen ein anderes ausgetauscht werden, welches zwar beispielsweise insgesamt niedrigere Transmissionsvermögen für Röntgenstrahlen zeigt, aber den speziellen Bereich deutlicher abbildet. Mit anderen Worten, wenn in unterschiedlichen Energiebereichen die Empfindlichkeit besonders hoch sein muss, können bestimmte Materialien bevorzugt werden; so hat ein 400nm Al-Fenster für Energien >300 eV eine bessere Transmission und damit höhere Empfindlichkeit als 1 $\mu m$ Mylar bei etwa gleicher maximaler Primärenergie, bei der Rückstreuelektronen noch vollständig unterdrückt werden, für Energien $\leq$ 300 eV jedoch eine schlechtere Transmission. Für die Analyse von Bor (B-K 183 eV) wäre hingegen ein 1 $\mu m$ Mylar-Fenster, sowie für Stickstoff (N-K 398 eV) ein 400 nm Al-Fenster bevorzugt. Die angegebenen Dicken können bevorzugt um 0,5 $\mu m$ nach oben und unten variieren.

Gleichzeitig unterdrücken alle diese Fenster einen Beitrag durch niederenergetische Sekundärelektronen, die andere Energie- und Z-Abhängigkeiten sowie Kontraste liefern.

In diesen Fällen ist nicht nur eine qualitative, sondern auch eine quantitative Analyse des Spektrenteils, der durch Photonen erzeugt wird, möglich.

Die Energieauflösung für Photonen liegt bevorzugt im Bereich von 130 eV für Mn-Ka.

Die in Figur 3 gezeigte Vorrichtung ist derart ausgebildet, dass die Fenster während des Betriebs, also insbesondere im Vakuum austauschbar sind. Dies ist besonders dann möglich, wenn der Austausch und/oder die Wahl des Fensters automatisiert sind. Hierzu werden Informationen über die Parameter der eingestellten Primärstrahlenergie über geeignete Steuerungssignale 44 zwischen von der Primärstrahlsteuerung 43 an die Steuerung 41 des Stellmittels 36 der Fenster gegeben. Die Steuerung 41 des Stellmittels erhält bei Änderung der Primärstrahlenergie ein Steuersignal 44. Nach einem Algorithmus wird dann ein Fenster ausgewählt. Nach der Verarbeitung der Informationen und Zuordnung der neuen Position der Halterung 35 wird ein Steuersignal 46 an das Stellmittel 36 gegeben welches einen Befehl zum Positionieren der Halterung 35 und damit Wechseln der Fenster enthält. Die Steuerung 41 des Positionierungsmechanismus der Fenster kann zusätzlich vom Bediener angewählt werden. Dies ist beispielsweise dann wichtig, wenn infolge einer Testmessung ein Fenstertausch vorgenommen werden soll um charakteristische Peaks quantifizieren zu können, das in Abhängigkeit der Primärstrahlenergie ausgewählte Fenster jedoch im kritischen Bereich einen zu starken Untergrund durchlässt.

Bei einem der Anregungsenergie angepassten Fenster können Spektren mit einem größeren Raumwinkel aufgenommen werden, somit ist eine schnellere Aufnahme oder die Aufnahme von Spektren mit besserer Statistik möglich. Bei geringeren Energien der Primärelektronen können dünnere Fenster verwendet werden, die eine bessere Transmission für Röntgenstrahlung aufweisen.

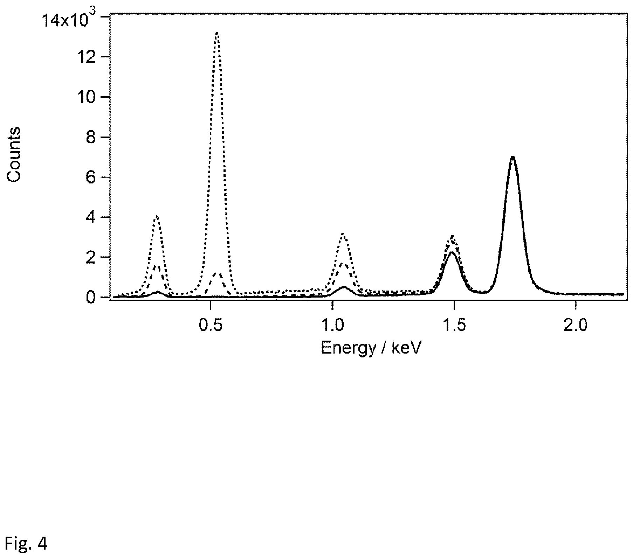

Figur 4 zeigt den Ausschnitt im Niederenergiebereich dreier erfindungsgemäß gemessener Spektren des Minerals Albit bestehend aus Sauerstoff, Natrium, Aluminium und Silizium, bedampft mit Kohlenstoff im Vergleich. Es sind fünf charakteristische Peaks ausgebildet. Die Messung wurde bei geringer Energie der Primärelektronen (6 keV) durchgeführt. Die Spektren sind dabei normiert auf den Peak höchster Energie, bei 1.74keV Das durchgezogene Spektrum zeigt eine vergleichsweise schlechte Fenster-Transmission (Mylar, 7 μm Dicke) aufgrund eines dickeren Fensters. Dies entspricht einem Detektor ohne Niederenergie-Performance. Durch Austausch gegen ein Fenster mittlerer Dicke (gestrichelt), kann die Fenster-Transmission für Röntgenstrahlung erhöht und immer noch die BSE vollständig unterdrückt werden (Mylar, 3 μm). Durch Austausch gegen ein dünnes Fenster (gepunktet), kann die Fenster-Transmission soweit erhöht werden, wie es sonst nur durch Verwendung eines dünnen Fensters mit Elektronenfalle möglich ist (Mylar, 1μm). Es wird deutlich, dass insbesondere die Peaks bei 0,25 keV und 0.5 keV ohne diese Niederenergieperformance nicht quantitativ auswertbar wären.

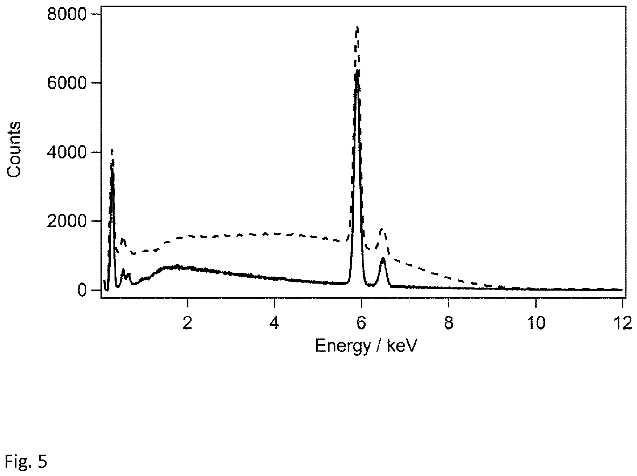

Ein anderes Beispiel ist in Figur 5 gezeigt. Hier wurde eine Mangan (Mn)-Probe mittels einer Primärstrahlenergie von 14 keV erfindungsgemäß gemessen. Wie in Figur 4 wurden zwei verschiedene Messungen zweier Fensterdicken des gleichen Materials verglichen. Dabei zeigt die durchgezogene Linie ein 4 μm dickes Fenster aus Mylar, wohingegen das zur gestrichelten Linie gehörige Fenster mit 3 μm Mylar vor dem Röntgendetektionselement gemessen wurde. Beide Linien wurden, ebenso wie die Spektren in Figur 4 nicht vom Röntgenuntergrund bereinigt. Der dadurch entstandene Einfluss ist im Bereich zwischen 1 keV und 9 keV zu erkennen. Während die Messung mit dünnerem Fenster (3 μm) jedoch einen erheblichen Anteil an Rückstreuelektronen auch im niederenergetischen Bereich detektiert, ist dieser Anteil in der Messung mit dem dickeren Fenster (4 μm) vernachlässigbar. Die charakteristischen Peaks von Mangan werden im Bereich zwischen 5 und 7 eV erwartet. Bei der Messung mit dem für diese Probe und diese Primärenergie optimierten Fenster von 4 μm Mylar sind die Peak nicht nur qualitativ, sondern auch quantitativ genauer auswertbar.

Bezugszeichenliste

| | |
|---|---|
| 10 | Polschuh |
| 11 | Primärelektronenstrahl |
| 12 | Rückstreuelektronen |
| 13 | Röntgenstrahlen |
| 20 | Probe |
| 30 | Detektor |
| 31 | Detektionselement |
| 32 | Elektronenfalle |
| 33 | Fenster |
| 34 | Mittel zur Reduktion von Rückstreuelektronen |
| 35 | Halterung |
| 36 | Stellmittel |
| 40 | Hardware/Software-Einheit |
| 41 | Steuerung Stellmittel |
| 42, 44, 46 | Steuersignal |
| 43 | Steuereinheit Polschuh |

**Patentansprüche**

1.  Verfahren zur energiedispersiven Detektion von Röntgenstrahlung, umfassend folgende Schritte:

    - Bestrahlen einer Probe (20) mit einem Primärelektronenstrahl (11) unter Anregung einer Emission von Röntgenstrahlung (13) und Rückstreuelektronen (12),
- Bereitstellen eines Mittels (34) zur Reduktion der Rückstreuelektronen (12), umfassend eine Halterung (35) mit mindestens zwei Fenstern (33) mit unterschiedlichen Transmissionseigenschaften für Rückstreuelektronen (12),
- Positionieren eines der mindestens zwei Fenster der Halterung (35) zwischen einem Röntgendetektionselement (31) und einer Probe (20) und
- Detektieren der Röntgenstrahlung (13) mittels des Röntgendetektionselements (31),

wobei von den mindestens zwei Fenstern (33) der Halterung (35) dasjenige ausgewählt und zwischen dem Röntgendetektionselement (31) und der Probe (20) positioniert wird, das in einem vorbestimmten Energiebereich an jedem charakteristischen Röntgenpeak den größtmöglichen Transmissionsgrad $T_X$ für Röntgenstrahlen aufweist, wobei der Transmissionsgrad $T_{BSE}$ für Rückstreuelektronen höchstens 0,1 beträgt.

2.  Verfahren nach Anspruch 1, wobei der Transmissionsgrad $T_{BSE}$ höchstens 0,05, insbesondere höchstens 0,02 beträgt.

3.  Verfahren nach einem der vorhergehenden Ansprüche, wobei die unterschiedlichen Transmissionseigenschaften der Fenster durch unterschiedliche Fenstermaterialien realisiert werden.

4.  Verfahren nach einem der vorhergehenden Ansprüche, wobei die unterschiedlichen Transmissionseigenschaften der Fenster durch unterschiedliche Fensterdicken dF realisiert werden.

5.  Verfahren nach Anspruch 4, wobei die Dicke dF der Fenster (33) im Bereich von 0,1 μm bis 20 μm liegen.

6.  Verfahren nach einem der vorhergehenden Ansprüche, wobei das Fenster (33) manuell und/oder automatisch zwischen dem Röntgendetektionselement (31) und der Probe (20) positioniert wird.

7.  Verfahren nach einem der vorhergehenden Ansprüche, wobei das zwischen dem Röntgendetektionselement (31) und der Probe (20) positionierte Fenster während des Betriebs, insbesondere im Vakuum, durch ein anderes der mindestens zwei Fenster ausgetauscht wird.

8.  Verfahren nach Anspruch 7, wobei der Austausch der Fenster mittels einer Hardware/Software-Einheit gesteuert wird.

9.  Verfahren nach einem der vorhergehenden Ansprüche, wobei die Auswahl des Fensters in Abhängigkeit von der Energie des Primärelektronenstrahls erfolgt.

10. Verfahren nach einem der vorhergehenden Ansprüche, wobei die Auswahl des vor dem Röntgendetektionselement positionierten Fensters in Abhängigkeit von der Transmission bestimmter Linien des Spektrums bei einer Testmessung erfolgt.

11. Vorrichtung zur energiedispersiven Detektion von Röntgenstrahlung, umfassend: ein Röntgendetektionselement (31) sowie ein Mittel (34) zur Reduktion von in das Röntgendetektionselement (31) einfallenden Rückstreuelektronen, wobei das Mittel (34) eine Halterung (35) mit mindestens zwei Fenstern (33) umfasst, welche unterschiedliche Transmissionseigenschaften für Elektronen aufweisen und das Mittel (34) einen, zur Ausführung des Verfahrens nach einem der Ansprüche 1 bis 10 eingerichteten Algorithmus umfasst.

12. Vorrichtung nach Anspruch 11, wobei die Halterung ausgebildet ist, verschiedene Positionen einzunehmen, so dass jeweils eines der Fenster (33) in einer optischen Achse des Röntgendetektionselements (31) positionierbar ist.

## Claims

1.  A method for the energy-dispersive detection of X-radiation, comprising the following steps:

    - irradiating a sample (20) with a primary electron beam (11) so as to excite an emission of X-radiation (13) and back-scattered electrons (12),
    - providing a means (34) for reducing the back-scattered electrons (12), comprising a holder (35) having at least two windows (33) which have different transmission properties for back-scattered electrons (12),
    - positioning one of the at least two windows of the holder (35) between an X-ray detection element (31) and a sample (20), and
    - detecting the X-radiation (13) by means of the X-ray detection element (31),

    wherein the one of the at least two windows (33) of the holder (35) is selected and positioned between the X-ray detection element (31) and the sample (20) which has the greatest possible transmittance Tx for X-rays in a predetermined energy range at each characteristic X-ray peak, wherein the transmittance $T_{BSE}$ for back-scattered electrons is at most 0.1.

2.  The method according to Claim 1, wherein the transmittance $T_{BSE}$ is at most 0.05, in particular at most 0.02.

3. The method according to any one of the preceding claims, wherein the different transmission properties of the windows are realized by different window materials.

4. The method according to any one of the preceding claims, wherein the different transmission properties of the windows are realized by different window thicknesses dF.

5. The method according to Claim 4, wherein the thickness dF of the windows (33) is in the range from 0.1 $\mu$m to 20 $\mu$m.

6. The method according to any one of the preceding claims, wherein the window (33) is positioned manually and/or automatically between the X-ray detection element (31) and the sample (20).

7. The method according to any one of the preceding claims, wherein the window positioned between the X-ray detection element (31) and the sample (20) is replaced by another of the at least two windows during operation, in particular in a vacuum.

8. The method according to Claim 7, wherein the replacement of the windows is controlled by means of a hardware/software unit.

9. The method according to any one of the preceding claims, wherein the window is selected according to the energy of the primary electron beam.

10. The method according to any one of the preceding claims, wherein the window positioned in front of the X-ray detection element is selected according to the transmission of certain lines of the spectrum during a test measurement.

11. A device for the energy-dispersive detection of X-radiation, comprising: an X-ray detection element (31) and a means (34) for reducing back-scattered electrons incident in the X-ray detection element (31), wherein the means (34) comprises a holder (35) having at least two windows (33) which have different transmission properties for electrons, and the means (34) comprises an algorithm designed to carry out the method according to any one of Claims 1 to 10.

12. The device according to Claim 11, wherein the holder is designed to assume different positions such that in each case one of the windows (33) can be positioned in an optical axis of the X-ray detection element (31).

**Revendications**

1. Procédé de détection à dispersion d'énergie de rayons X, comprenant les étapes suivantes :

   - l'irradiation d'un échantillon (20) par un faisceau électronique primaire (11) moyennant la stimulation de l'émission de rayons X (13) et d'électrons rétrodiffusés (12),
   - la fourniture d'un moyen (34) visant à réduire les électrons rétrodiffusés (12), comprenant un support (35) avec au moins deux fenêtres (33) présentant différentes propriétés de transmission des électrons rétrodiffusés (12),
   - le positionnement d'une des deux fenêtres au moins du support (35) entre un élément de détection de rayons X (31) et un échantillon (20) et
   - la détection de rayons X (13) au moyen d'un élément de détection de rayons X (31),

   dans lequel parmi les deux fenêtres au moins (33) du support (35), celle qui présente le facteur de transmission Tx maximal des rayons X à chaque crête de rayon X caractéristique dans un domaine d'énergie prédéterminé est choisie et positionnée entre l'élément de détection de rayons X (31) et l'échantillon (20), dans lequel le facteur de transmission $T_{BSE}$ des électrons rétrodiffusés s'élève à 0,1 au maximum.

2. Procédé selon la revendication 1, dans lequel le facteur de transmission $T_{BSE}$ s'élève à 0,05 au maximum, en particulier à 0,02 au maximum.

3. Procédé selon l'une quelconque des revendications précédentes, dans lequel les différentes propriétés de transmission des fenêtres sont obtenues moyennant divers matériaux de fenêtre.

4. Procédé selon l'une quelconque des revendications précédentes, dans lequel les différentes propriétés de transmission des fenêtres sont obtenues moyennant diverses épaisseurs de fenêtre dF.

5. Procédé selon la revendication 4, dans lequel l'épaisseur dF des fenêtres (33) se situe dans la plage de 0,1 $\mu$m à 20 $\mu$m.

6. Procédé selon l'une quelconque des revendications précédentes, dans lequel la fenêtre (33) est positionnée manuellement et / ou automatiquement entre l'élément de détection de rayons X (31) et l'échantillon (20).

7. Procédé selon l'une quelconque des revendications précédentes, dans lequel la fenêtre positionnée entre l'élément de détection de rayons X (31) et l'échantillon (20) est remplacée durant l'exploitation, notamment dans le vide, par une autre des deux fenêtres au moins.

8. Procédé selon la revendication 7, dans lequel le remplacement des fenêtres est commandé au moyen d'une unité matérielle / logicielle.

9. Procédé selon l'une quelconque des revendications précédentes, dans lequel la sélection de la fenêtre s'effectue en fonction de l'énergie du faisceau électronique primaire.

10. Procédé selon l'une quelconque des revendications précédentes, dans lequel la sélection de la fenêtre positionnée devant l'élément de détection de rayons X s'effectue en fonction de la transmission de certaines raies du spectre lors d'une mesure de test.

11. Dispositif de détection à dispersion d'énergie de rayons X, comprenant : un élément de détection de rayons X (31) ainsi qu'un moyen (34) visant à réduire les électrons rétrodiffusés incidents dans l'élément de détection de rayons X (31), dans lequel le moyen (34) comprend un support (35) avec au moins deux fenêtres (33), lesquelles présentent différentes propriétés de transmission des électrons et le moyen (34) comporte un algorithme ajusté pour exécuter le procédé selon l'une quelconque des revendications 1 à 10.

12. Dispositif selon la revendication 11, dans lequel le support est conçu pour prendre différentes positions, de sorte que l'une des fenêtres (33) peut être respectivement placée dans un axe optique de l'élément de détection de rayons X (31).

Fig. 1

Fig. 2

Fig. 3

Fig. 4

REPLACED

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010115873 A
- EP 2216798 A
- US 7709820 B2
- US 20130094629 A1